# EUROPEAN PATENT APPLICATION

(11) **EP 3 667 716 A1**
(43) Date of publication of application: **17.06.2020**
(21) Application number: 18845233.8
(22) Date of filing: 27.04.2018
(51) Int. Cl.: H01L 23/12, H01P 5/08, H05K 1/14, H01L 23/40

(54) **CIRCUIT BOARD AND ELECTRONIC DEVICE**

(30) Priority: 10.08.2017 JP 2017155669
(71) Applicant: Fujikura Ltd., Tokyo 135-8512 (JP)
(72) Inventor: MATSUMARU, Kohei, Sakura-shi, Chiba 285-8550 (JP)
(74) Representative: Lavoix
(86) International application number: PCT/JP2018/017175
(87) International publication number: WO 2019/030994

(57) **Abstract**

A circuit board includes: a first board; a second board; an electronic element connected to the first board via a first connecting portion, and connected to the second board via a second connecting portion, in which a thermal conductance of the second connecting portion is smaller than a thermal conductance of the first connecting portion.

## Description

### TECHNICAL FIELD

The present invention relates to a circuit board and an electronic device.

Priority is claimed on Japanese Patent Application No. 2017-155669, filed August 10, 2017, the content of which is incorporated herein by reference.

### BACKGROUND ART

There is a significant progress in downsizing an electronic device such as a wireless communication device.

For example, Patent Document 1 discloses a module-integrated antenna in which an electronic element such as an RFIC, an antenna transmission line, an antenna, and the like are provided in a multilayer board.

On the other hand, Patent Document 2 proposes a millimeter-wave radio system using a board in which a material having a small dielectric loss, such as a fluororesin material, is used for a transmission line between a transceiver IC and an antenna.

### PRIOR ART DOCUMENTS

### PATENT DOCUMENTS

[Patent Document 1] Japanese Unexamined Patent Application, First publication No. 2003-188626
[Patent Document 2] United States Patent No. 8674885

### DISCLOSURE OF INVENTION

### PROBLEMS TO BE SOLVED BY THE INVENTION

According to a technology disclosed in Patent Document 1, electronic elements to be heat sources, such as a transceiver IC and a chip component, and an antenna are integrated on the same board. Heat generated from such electronic elements by energization is dissipated from surfaces of the electronic elements and thermally conducted to the board through a connecting portion with the board. Therefore, an antenna transmission line and a conductor (e.g., copper) of an antenna circuit portion on the board are also heated. As a result, there may be a case where the resistivity of the circuit is increased, and characteristic impedance is deviated and/or oxidation of the conductor is accelerated, thereby degrading reliability.

Particularly, in a case of an antenna transmission line used in a millimeter-wave band, a protective film may not be provided because, in a case where the conductor of the antenna transmission line is coated with a protective film having a high dielectric constant, characteristics are deteriorated. In this case, the acceleration of oxidation particularly is likely to occur due to a temperature increase in the board.

Furthermore, there may be a case where antenna characteristics are changed and reliability is degraded also by distortion of the board caused by the temperature increase in the board.

Therefore, for example, it is conceivable to increase the heat capacity of the board or arrange the electronic elements to be the heat sources at positions distant from a region easily affected by the temperature increase. However, with such a constitution, it is difficult to achieve downsizing and weight reduction of a device.

Thus, there is a need for a circuit board structure capable of preventing deterioration of circuit characteristics and degradation of reliability even though heat concentration occurs on the circuit board due to the downsizing and the weight reduction.

As disclosed in Patent Document 2, a board having a small dielectric loss is used in a wireless communication device. However, the board having the small dielectric loss is expensive. For example, under the present circumstances, a price of the board including a fluorine-based material and having the small dielectric loss is approximately 10 times that of an FR4 board. Additionally, in a case of using the fluororesin material as a board material, adhesion between the board and a conductor becomes deteriorated, and therefore, a manufacturing cost is increased in order to secure the adhesion of the conductor, in addition to the high material cost.

Thus, the cost for the board-integrated wireless communication device tends to be high.

The present invention is made in view of the above-described circumstances and provides a circuit board and an electronic device capable of suppressing deterioration of circuit characteristics and degradation of reliability even though a mounted electronic element generates heat.

### MEANS FOR SOLVING THE PROBLEMS

In a first aspect of the present invention, provided is a circuit board including: a first board; a second board; an electronic element connected to the first board via a first connecting portion, and connected to the second board via a second connecting portion, in which the thermal conductance of the second connecting portion is smaller than the thermal conductance of the first connecting portion.

In a second aspect of the present invention, the first board and the second board may be arranged with a gap between each other in the circuit board according to the first aspect.

In a third aspect of the present invention, the first board and the second board may be formed of materials different from each other in the circuit board according to the first or second aspect.

In a fourth aspect of the present invention, the second board may have a dielectric loss smaller than a dielectric loss of the first board in the circuit board according to any one of the first to third aspects.

In a fifth aspect of the present invention, the second board may have the dielectric loss larger than zero and smaller than 0.02 in the circuit board according to the fourth aspect.

In a sixth aspect of the present invention, the second board may include an antenna transmission line in the circuit board according to any one of the first to fifth aspects.

In a seventh aspect of the present invention, the second board may not necessarily have an electronic component mounted except for the electronic element in the circuit board according to any one of the first to sixth aspects.

In an eighth aspect of the present invention, provided is an electronic device including a circuit board according to any one of the first to seventh aspects.

### EFFECTS OF THE INVENTION

According to the circuit board and the electronic device of the aspects according to the above-described present invention, deterioration of circuit characteristics and degradation of reliability can be suppressed even though the mounted electronic element generates heat.

### BRIEF DESCRIPTION OF THE DRAWINGS

Fig. 1A is a schematic plan view showing an exemplary example of a circuit board according to a first embodiment.
Fig. 1B is a cross-sectional view taken along a line A-A in Fig. 1A.
Fig. 2A is a schematic plan view showing an exemplary example of a circuit board according to a second embodiment.
Fig. 2B is a cross-sectional view taken along a line A-A in Fig. 2A.
Fig. 3A is a schematic plan view showing an exemplary example of a circuit board according to a third embodiment.
Fig. 3B is a cross-sectional view taken along a line A-A in Fig. 3A.
Fig. 4A is a schematic plan view showing an exemplary example of a circuit board according to a fourth embodiment.
Fig. 4B is a cross-sectional view taken along a line A-A in Fig. 4A.
Fig. 5A is a schematic plan view showing an exemplary example of a circuit board according to a fifth embodiment.
Fig. 5B is a cross-sectional view taken along a line A-A in Fig. 5A.

### EMBODIMENTS FOR CARRYING OUT THE INVENTION

Hereinafter, embodiments of the present invention will be described with reference to the attached drawings. In all of the drawings, the same or corresponding members will be denoted by the same reference sings even in a case where embodiments are different, and a common description will be omitted.

### First Embodiment

A circuit board and an electronic device according to a first embodiment of the present invention will be described.

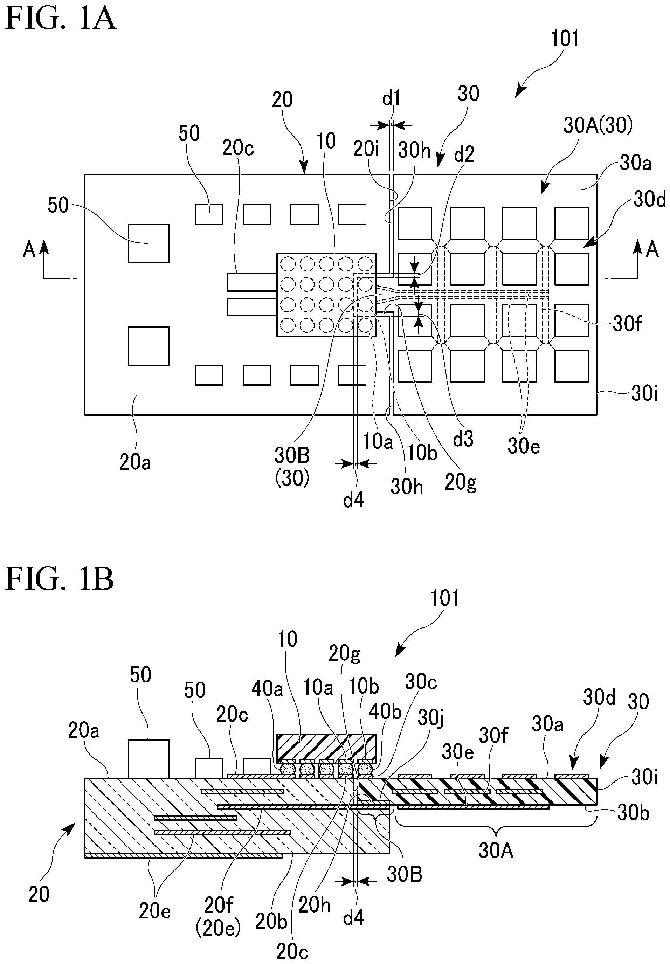

Fig. 1A is a schematic plan view showing an exemplary example of a circuit board according to the first embodiment. Fig. 1B is a cross-sectional view taken along a line A-A in Fig. 1A.

Note that, since Fig. 1A and Fig. 1B are the schematic views, dimensions and shapes are exaggerated or simplified (the similar applies to the drawings in the following).

A circuit board 101 of the present embodiment shown in Figs. 1A and 1B can constitute at least a part of an appropriate electronic device. An example of such an electronic device using the circuit board 101 can include a wireless communication device or the like.

Hereinafter, a case where the circuit board 101 is used in the wireless communication device will be described as an example.

The circuit board 101 includes a transceiver circuit board 20 (first board), a transceiver IC 10 (electronic element), electronic components 50, and an antenna circuit board 30 (second board).

For example, the transceiver circuit board 20 is formed with an electronic circuit having circuit characteristics hardly affected by a dielectric loss of the board in the wireless communication device. Specifically, the electronic circuit excluding an antenna and a transmission circuit to the antenna is formed.

A board constitution of the transceiver circuit board 20 is not particularly limited. The transceiver circuit board 20 may be a single layer board or a multilayer board. It is more preferable to use the multilayer board as the transceiver circuit board 20 in terms of downsizing.

As a board material of the transceiver circuit board 20, it is not particularly necessary to use a material having a low dielectric loss. For example, the board material of the transceiver circuit board 20 may have the dielectric loss of 0.02 or more. Here, the dielectric loss of the board material is the product of a relative dielectric constant and a dielectric loss tangent.

More preferably, the board material of the transceiver circuit board 20 is a material having high thermal conductivity in terms of achieving a favorable heat dissipation effect. For example, the board material of the transceiver circuit board 20 may have the thermal conductivity of 0.2 W/(m·K) or more and 20 W/(m·K) or less. For example, an epoxy resin has a thermal conductivity of 0.2 W/(m·K), and alumina has a thermal conductivity of 20 W/(m·K).

Specific examples of the material of the transceiver circuit board 20 can include glass epoxy (FR4), a polyphenylene ether (PPE) resin, a polyimide (PI) resin, glass alumina (LTCC), and the like, for example. As the transceiver circuit board 20, it is more preferable to use an FR4 board that is advantageous in terms of a cost.

In an example of the FR4 board, a relative dielectric constant is 4.8, a dielectric loss tangent is 0.015, and thermal conductivity is 0.8 W/(m·K). In the case of such a FR4 board, a dielectric loss is 0.072.

The transceiver circuit board 20 has a shape not particularly limited. In the example shown in Figs. 1A and 1B, the transceiver circuit board 20 has a rectangular shape in the plan view. However, a recessed portion 20g having a rectangular shape in the plan view is formed toward the inside of the board at a center portion of a board side surface 20i constituting one side of the transceiver circuit board 20. The recessed portion 20g may be formed by applying, for example, counterbore processing to the transceiver circuit board 20.

A plurality of wires 20e that forms a circuit by electrically connecting the electronic components 50 to the transceiver IC 10 is formed in an inner layer and a second surface 20b of the transceiver circuit board 20, and the second surface 20b is located on an opposite side of a first surface 20a. However, since Fig. 1B is the schematic view, a conductor such as a via that mutually connects the respective wires 20e is not shown.

Among the plurality of wires 20e, a ground (GND) pattern 20f extends onto a bottom surface 20h of the recessed portion 20g in the present embodiment.

On the first surface 20a, mounting terminals (partially not shown) are exposed as necessary. The plurality of electronic components 50 and the transceiver IC 10 are mounted at the mounting terminals (partially not shown) on the first surface 20a.

Examples of the electronic components 50 can include a resistor, a capacitor, an oscillator, an inductor, and a connector, for example. Each electronic component 50 is more preferably formed of a chip component in order to downsize the circuit board 101.

The electronic components 50 may be mounted on the transceiver circuit board 20 by solder reflow mounting, for example.

The electronic components 50 may also include a control IC for a wireless transceiver device. However, the control IC may also be arranged outside the transceiver circuit board 20 via a connector (not shown) connected to the transceiver circuit board 20.

The transceiver IC 10 modulates and amplifies an input signal, sends out a transmission signal to the antenna circuit board 30 described later, and further amplifies and demodulates a reception signal sent out from the antenna circuit board 30 to generate an output signal.

The transceiver IC 10 includes: a second terminal 10b that is a transceiver I/O terminal to input/output a reception signal and a transmission signal; and a first terminal 10a that connects a data signal line, a control signal line, a power source, and a GND. In the present embodiment, for example, a BGA package is used for the transceiver IC 10. Therefore, both the second terminal 10b and the first terminal 10a are exposed on a lower surface of the transceiver IC 10. The transceiver IC 10 is mounted by a flip chip method on the first surface 20a of the transceiver circuit board 20 and a first surface 30a of the antenna circuit board 30 described later.

However, the second terminal 10b is arranged at a position facing the first surface 30a of a protruding portion 30B of the antenna circuit board 30 described later, whereas the first terminal 10a is arranged at a position facing the first surface 20a of the transceiver circuit board 20.

On the first surface 20a positioned in the vicinity of the recessed portion 20g of the transceiver circuit board 20, a connection terminal 20c corresponding to each first terminal 10a is provided at a position facing each first terminal 10a (see Fig. 1B).

Each first terminal 10a of the transceiver IC 10 is electrically connected to each corresponding connection terminal 20c on the first surface 20a of the transceiver circuit board 20 via a first connecting portion 40a (first connecting portion).

As the first connecting portion 40a, a bump, solder, conductive paste, or the like may be used, for example.

The antenna circuit board 30 includes: a board body 30A having a rectangular shape in the plan view; and the protruding portion 30B protruding from a center portion of a board side surface 30h that is one side surface of the board body 30A.

The protruding portion 30B is formed in a rectangular shape in the plan view so as to be able to be fitted into the recessed portion 20g of the transceiver circuit board 20 with a gap.

The first surface 30a positioned at the protruding portion 30B of the antenna circuit board 30 is provided with an RF input/output terminal 30c for connection to each second terminal 10b of the transceiver IC 10. In the present embodiment, a second surface 30b positioned at the protruding portion 30B is provided with a GND pattern 30j for electrical connection to a GND pattern 20f. As an electrical connection method between the GND pattern 20f and the GND pattern 30j, it is possible to adopt a known appropriate connection method between GND patterns.

Each second terminal 10b of the transceiver IC 10 is electrically connected to each RF input/output terminal 30c on the first surface 30a positioned at the protruding portion 30B of the antenna circuit board 30 via a second connecting portion 40b (second connecting portion).

As the second connecting portion 40b, for example, a bump, solder, conductive paste, or the like may be used in a manner similar to the first connecting portion 40a.

The first surface 30a positioned at the board body 30A of the antenna circuit board 30 is arranged with a planar antenna 30d in which a plurality of conductor patterns is two-dimensionally arranged at an appropriate pitch. In Fig. 1A, as an example of the planar antenna 30d, sixteen rectangular conductor patterns are arranged in a 4 × 4 rectangular lattice-like form.

As shown in Fig. 1B, an antenna transmission line 30e is formed on the second surface 30b positioned at the board body 30A. The antenna transmission line 30e has a pattern not particularly limited, but in the present embodiment, for example, the pattern is formed below each RF input/output terminal 30c in the drawing in a manner extending substantially linearly from the protruding portion 30B side toward a side of a board side surface 30i facing the board side surface 30h (see Fig. 1B).

More preferably, the antenna circuit board 30 has a thickness of 100 µm or more in order to obtain appropriate antenna characteristics.

The antenna circuit board 30 has an inner layer appropriately provided with a wire that electrically connects a circuit on the first surface 30a and a circuit on the second surface 30b to each other.

For example, the RF input/output terminal 30c and the antenna transmission line 30e are electrically connected to each other through an antenna transmission line 30f and a conductor such as a via (not shown) which are included in the inner layer of the antenna circuit board 30.

For example, the planar antenna 30d and the antenna transmission line 30e are electrically connected to each other through the antenna transmission lines 30f and a conductor such as a via (not shown).

The GND pattern 30j is electrically connected to another GND pattern in the antenna circuit board 30 through a conductor such as a via (not shown).

With this constitution, the RF input/output terminal 30c and the planar antenna 30d are conductive with each other through the wires such as antenna transmission lines 30e and 30f formed on the antenna circuit board 30.

A board material of the antenna circuit board 30 may include a material having a dielectric loss lower than that of the transceiver circuit board 20. More preferably, the dielectric loss of the board material of the antenna circuit board 30 is larger than zero and smaller than 0.02, for example.

For example, a liquid crystal polymer (LCP) board having an induced loss smaller than that of the FR4 is used for the antenna circuit board 30 of the present embodiment in accordance with a fact that the transceiver circuit board 20 is formed of FR4. For example, an exemplary example of an LCP board has a relative dielectric constant of 2.9, a dielectric loss tangent of 0.002, and thermal conductivity of 0.5 W/(m·K). This LCP board has the dielectric loss of 0.0058.

Examples of a preferable material as the board material of the antenna circuit board 30 can include a fluorine-based material, a hydrocarbon-based ceramic material, and the like, for example.

An example of the fluorine-based board material containing polytetrafluoroethylene (PTFE) can include RT/duroid (registered trademark) (trade name; manufactured by Rogers Corporation). The RT/duroid (registered trademark) has a relative dielectric constant, a dielectric loss tangent, a dielectric loss, and thermal conductivity of 2.2, 0.0009, 0.00198, and 0.2 W/(m·K), respectively.

An example of the hydrocarbon-based ceramic material can include RO4350 (registered trademark) (trade name; manufactured by Rogers Corporation). The RO4350 (registered trademark) has a relative dielectric constant, a dielectric loss tangent, a dielectric loss, and thermal conductivity of 3.48, 0.0037, 0.012876, and 0.69 W/(m·K), respectively.

In the circuit board 101, the antenna circuit board 30 and the transceiver circuit board 20 are fixed in a state in which the second surface 30b positioned at the protruding portion 30B of the antenna circuit board 30 is superimposed on the recessed portion 20g of the transceiver circuit board 20. In the present embodiment, the first surface 30a of the antenna circuit board 30 and the first surface 20a of the transceiver circuit board 20 are arranged on the same plane. However, there may be a level difference between the first surfaces 30a and 20a as far as there is no problem in connection to the transceiver IC 10.

The respective side surfaces of the protruding portion 30B and an inner peripheral surface of the recessed portion 20g of the transceiver circuit board 20 are arranged with following gaps: a gap d4 (where d4 > 0) at an end in a protruding direction of the protruding portion 30B; and gaps d2 and d3 on both side surfaces in the protruding direction (where d2 > 0 and d3 > 0).

The board side surface 30h of the board body 30A and the board side surface 20i of the transceiver circuit board 20 are arranged with a gap d1 from each other (where d1 > 0). However, the gaps d1, d2, d3, and d4 are not necessarily constant, and the size of each of the gaps may be varied depending on a location. For example, the size of the gap d1 may be different from each other between the upper side and the lower side of Fig. 1A.

A fixing method of the antenna circuit board 30 and the transceiver circuit board 20 is not particularly limited. For example, soldering, bonding, screw fixing, male-female fitting, press fitting, or the like may be used. One of the above fixing methods may be used, or a combination of two or more of the above fixing methods may be used.

For example, in a case where the antenna circuit board 30 and the transceiver circuit board 20 are soldered to each other, the GND patterns 20f and 30j may also be similarly soldered.

For example, in a case where the antenna circuit board 30 and the transceiver circuit board 20 are bonded, a resin adhesive having thermal conductivity lower than that of the transceiver circuit board 20 may be used. In a case of using a conductive adhesive as the adhesive, the GND patterns 20f and 30j may also be electrically connected by the conductive adhesive.

For example, in a case where the antenna circuit board 30 and the transceiver circuit board 20 are bonded, an adhesive resin such as an epoxy resin may be charged between the transceiver IC 10 and the first surface 20a of the transceiver circuit board 20 and also between the transceiver IC 10 and the first surface 30a positioned at the protruding portion 30B in order to protect each second connecting portion 40b and each first connecting portion 40a, and keep adhesive strength. In the example of adopting the epoxy resin for sealing, the epoxy resin has a relative dielectric constant, a dielectric loss tangent, a dielectric loss, and thermal conductivity of 3.2, 0.01, 0.032, and 0.2 W/(m·K), respectively.

For example, in a case of fixing the antenna circuit board 30 and the transceiver circuit board 20 with screws, the GND patterns 20f and 30j may also be fastened with the fixing screws.

For example, in the case of fixing the antenna circuit board 30 and the transceiver circuit board 20 with the screws and in a case where a wiring pattern is not formed on a fixing portion, a sheet member having thermal conductivity lower than that of the transceiver circuit board 20 may be interposed therebetween. However, even though the sheet member is interposed and screwed, in a case of having a wiring pattern (such as the ground) that does not affect the circuit characteristics, the wiring pattern may be formed on the fixed portion.

Thus, in the transceiver circuit board 20 and the antenna circuit board 30, the air having thermal conductivity of 0.03 intervenes at least in ranges of the gaps d1, d2, d3, and d4 between the side surfaces of the protruding portion 30B and the inner peripheral surface of the recessed portion 20g of the transceiver circuit board 20 and between the board side surface 30h and the board side surface 20i.

Therefore, thermal conduction from the transceiver circuit board 20 is substantially limited to a contact portion between the bottom surface 20h of the recessed portion 20g and the protruding portion 30B.

In the circuit board 101, the transceiver IC 10 is mounted on the transceiver circuit board 20 and the antenna circuit board 30 by the flip chip method.

Specifically, each second terminal 10b of the transceiver IC 10 is electrically connected to each RF input/output terminal 30c via each second connecting portions 40b. Furthermore, each first terminal 10a of the transceiver IC 10 is electrically connected to each connection terminal 20c via each first connecting portion 40a.

Each second connecting portion 40b constitutes a thermal conduction path between the transceiver IC 10 and the antenna circuit board 30, and each first connecting portion 40a constitutes a thermal conduction path between the transceiver IC 10 and the transceiver circuit board 20, respectively. In the present embodiment, for example, the number of second terminals 10b is two, and the number of first terminals 10a is eighteen. Although it depends on the constitution of the transceiver IC 10, the number of the second terminals 10b may be two to fifty, whereas the number of the first terminals 10a may be approximately thirty to three hundred, for example.

Since the area of each second terminal 10b and the area of each first terminal 10a are substantially equal, the thermal conductance of the thermal conduction path formed by the second connecting portions 40b and the thermal conductance of the thermal conduction path formed by the first connecting portions 40a are substantially proportional to the number of the second terminals 10b and the number of first terminals 10a, respectively.

Accordingly, in a state in which the transceiver IC 10 is connected, the thermal conductance of the second connecting portions 40b is smaller than the thermal conductance of the first connecting portions 40a.

According to the circuit board 101 having the above-described constitution, when a control signal from the control IC (not shown) is received in the transceiver IC 10, a transmission data signal transmitted inside the transceiver circuit board 20 is received in each first terminal 10a of the transceiver IC 10 from each connection terminal 20c via each first connecting portion 40a.

The transmission data signal is modulated and amplified by the transceiver IC 10 and converted into a high-frequency transmission signal. The transmission signal is transmitted from each second terminal 10b to the antenna transmission line 30e via each second connecting portion 40b and each RF input/output terminal 30c. The transmission signal is further transmitted to the planar antenna 30d from the antenna transmission line 30e via the antenna transmission line 30f and radiated as an electromagnetic wave by the planar antenna 30d. Since the antenna circuit board 30 is formed of the board material having the low dielectric loss, signal deterioration caused by the antenna transmission lines 30e and 30f is suppressed.

A reception signal received by the planar antenna 30d follows a route reverse to that of the transmission signal and is transmitted from each second terminals 10b to the transceiver IC 10. The transceiver IC 10 amplifies and demodulates the reception signal to generate a low-frequency reception data signal. The reception data signal is transmitted to a circuit inside the transceiver circuit board 20 via each first terminal 10a, each first connecting portion 40a, and each connection terminal 20c.

Since the transmission data signal, the reception data signal, and the control signal have frequencies lower than those of the transmission signal and the reception signal, signal deterioration hardly occurs even though a material having a large dielectric loss is used as the board material of the transceiver circuit board 20.

When the wireless communication operation is thus performed, the electronic components 50 and the transceiver IC 10 on the transceiver circuit board 20 generate heat. A part of the heat generated in the electronic components 50 and the transceiver IC 10 is dissipated into the air from surfaces of the components. A remaining part of heat generated in the electronic components 50 and the transceiver IC 10 is thermally conducted through the wires, the terminals, and the like formed of a metal having high thermal conductivity.

Therefore, a temperature of the transceiver circuit board 20 is increased due to the thermal conduction via the first terminals 10a of the transceiver IC 10 and the electronic components 50.

Since the transceiver IC 10 is connected to the antenna circuit board 30 via the second connecting portions 40b, the part of the heat generated by the transceiver IC 10 is thermally conducted to the antenna circuit board 30 via the second connecting portions 40b. However, since the entire second connecting portions 40b have the thermal conductance smaller than the thermal conductance of the entire first connecting portions 40a, a thermal conduction amount to the antenna circuit board 30 is smaller than a thermal conduction amount to the transceiver circuit board 20 in accordance with a thermal conductance difference.

In addition, in the present embodiment, only the metal wires are formed on the antenna circuit board 30, and no electronic component to be a heat source other than the transceiver IC 10 is connected.

Furthermore, in the present embodiment, since the circuit board 101 is separated into the antenna circuit board 30 and the transceiver circuit board 20, thermal conduction between the antenna circuit board 30 and the transceiver circuit board 20 is efficiently suppressed. Particularly, in the present embodiment, since the gaps are formed between the antenna circuit board 30 and the transceiver circuit board 20, a direct thermal conduction amount between the transceiver circuit board 20 and the antenna circuit board 30 is also reduced, and the thermal conduction between the boards is further reduced.

Note that, in the present embodiment, the transceiver circuit board 20 and the antenna circuit board 30 are also thermally connected by the GND patterns 20f and 30j. However, a GND pattern of the transceiver circuit board 20 to which the GND pattern 20f is connected has the larger pattern area than that of a signal line pattern due to a function of the GND. Therefore, the heat thermally conducted from a GND terminal of the transceiver IC 10 to the GND pattern is diffused to a broad region of the surface and the inside of the transceiver circuit board 20. As a result, since the thermal conduction from the transceiver IC 10 does not concentrate on the GND pattern 20f, a heat amount thermally conducted to the antenna circuit board 30 through the GND patterns 20f and 30j is much less than a heat amount conducted from the transceiver IC 10 to the antenna circuit board 30 through the first connecting portions 40a.

Thus, according to the circuit board 101 of the present embodiment, even when the heat of the electronic components 50 and the transceiver IC 10 is continuously generated, the thermal conduction to the antenna circuit board 30 is suppressed, and therefore, a temperature increase in the antenna circuit board 30 is more suppressed than in the transceiver circuit board 20.

Since the temperature increase in the antenna circuit board 30 is suppressed, it is possible to prevent: deviation of characteristic impedance caused by increase in a resistivity of the circuit in the antenna circuit board 30; and degradation of reliability caused by acceleration of oxidation of a conductor.

Furthermore, it is possible to prevent a change in the antenna characteristics and degradation of the reliability which are caused by distortion of the board due to the temperature increase in the antenna circuit board 30.

In the circuit board 101, the circuit is formed in manner separated into the antenna circuit board 30 and the transceiver circuit board 20. Since the antenna circuit board 30 is formed with only the circuit including the planar antenna 30d and the antenna transmission lines 30e and 30f which are largely affected by the induced loss, the area of the antenna circuit board 30 is more reduced than the area in a case of including another circuit.

In contrast, another circuit not much affected by the dielectric loss is formed on the transceiver circuit board 20 that can be formed at a cost lower than that of the board material of the antenna circuit board 30.

Thus, as for the circuit board 101, since the board area of the antenna circuit board 30 that is expensive due to having the low dielectric loss is confined to a part of the circuit board 101, a total component cost can be reduced by using the less expensive board material as the transceiver circuit board 20. For example, there is a case where a component cost of the fluorine-based material board becomes approximately 10 times as much as a component cost of the FR4 board.

Particularly, the board material having the low dielectric loss increases a manufacturing cost for forming a wiring pattern with metal conductors, but since the area of the antenna circuit board 30 is decreased, the increase in the manufacturing cost is also suppressed.

As described above, according to the circuit board 101 of the present embodiment and an electronic device such as a wireless communication device including the circuit board 101, deterioration of the circuit characteristics and degradation of the reliability can be suppressed even though the mounted electronic element generates the heat, and furthermore the cost can be reduced.

### Second Embodiment

A circuit board and an electronic device according to a second embodiment of the present invention will be described.

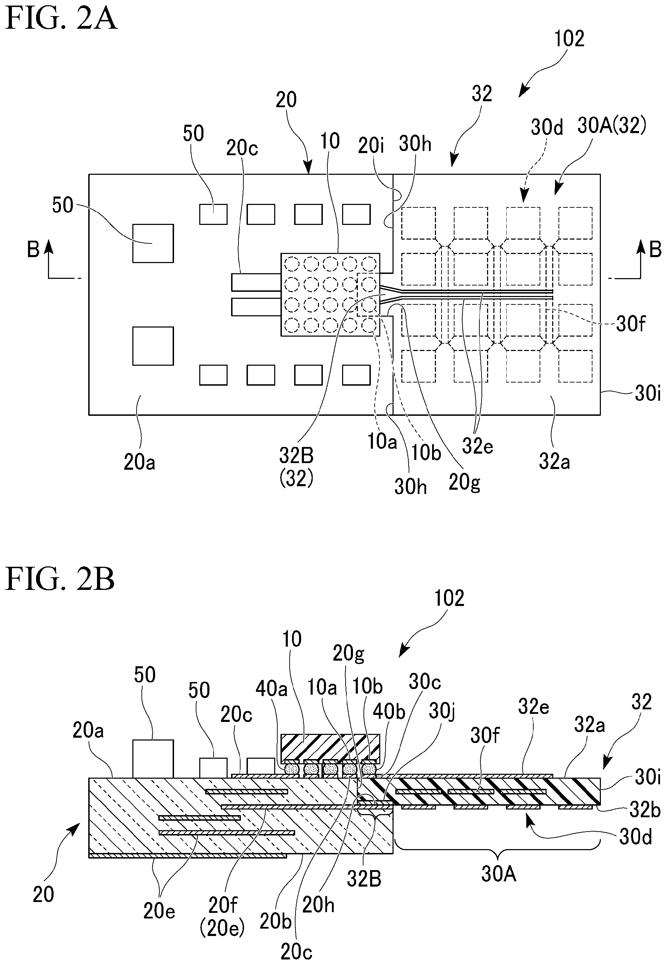

Fig. 2A is a schematic plan view showing an exemplary example of a circuit board according to the second embodiment. Fig. 2B is a cross-sectional view taken along a line B-B in Fig. 2A.

As shown in Figs. 2A and 2B, a circuit board 102 of the present embodiment includes an antenna circuit board 32 (second board) instead of the antenna circuit board 30 of the circuit board 101 of the first embodiment.

The circuit board 102 can constitute at least a part of an appropriate electronic device in a manner similar to the circuit board 101 of the first embodiment.

In the following, different points from the first embodiment will be mainly described.

The antenna circuit board 32 includes a board body 30A and a protruding portion 32B which are similar to those of the first embodiment. A first surface 32a positioned at the board body 30A and the protruding portion 32B is arranged on the same plane as a first surface 20a of a transceiver circuit board 20. However, similar to the first embodiment, there may be a level difference between the first surfaces 32a and 20a as far as there is no problem in connection to the transceiver IC 10.

A shape in the planar view of the protruding portion 32B is a rectangular shape that is fitted into an inner peripheral surface of a recessed portion 20g.

The antenna circuit board 32 includes an antenna transmission line 32e instead of the antenna transmission line 30e in the first embodiment, and includes a planar antenna 30d, an antenna transmission line 30f, and a GND pattern 30j which are similar to those of the first embodiment. However, in the antenna circuit board 32, a positional relation between the planar antenna 30d and the antenna transmission line 32e is different from that of the first embodiment.

The antenna transmission line 32e extends onto the first surface 32a from each RF input/output terminal 30c formed on the first surface 32a positioned at the protruding portion 32B in a manner similar to the first embodiment. The antenna transmission line 32e has a pattern not particularly limited, but in the present embodiment, for example, the pattern is formed in a substantially linear shape extending in a direction toward a board side surface 30i from the protruding portion 32B.

The planar antenna 30d of the present embodiment is formed on a second surface 32b on an opposite side of the first surface 32a positioned at the board body 30A.

The antenna circuit board 32 has an inner layer appropriately provided with a wire that electrically connects a circuit on the first surface 32a and a circuit on the second surface 32b to each other.

For example, the antenna transmission line 32e and the planar antenna 30d are electrically connected to each other through the antenna transmission line 30f and a conductor such as a via (not shown) which are included in the inner layer of the antenna circuit board 32 similar to that of the first embodiment.

A board material of the antenna circuit board 32 is a board material similar to that of the antenna circuit board 30 of the first embodiment.

In the circuit board 102, the second surface 32b positioned at the protruding portion 32B of the antenna circuit board 32 is superimposed on a bottom surface 20h of the recessed portion 20g of the transceiver circuit board 20, and the antenna circuit board 32 and the transceiver circuit board 20 are fixed in a state that the protruding portion 32B is fitted into the recessed portion 20g.

Each of side surfaces of the protruding portion 32B and the inner peripheral surface of the recessed portion 20g of the transceiver circuit board 20 are arranged in a manner entirely or substantially entirely abutting on each other.

As a fixing method of the antenna circuit board 32 and the transceiver circuit board 20, a method similar to any one of those provided as exemplary examples in the first embodiment is used.

The circuit board 102 of the present embodiment differs from the first embodiment in that: the planar antenna 30d is formed on the second surface 32b; each of the side surfaces of the protruding portion 32B abuts on the inner peripheral surface of the recessed portion 20g of the transceiver circuit board 20.

Therefore, according to the circuit board 102, wireless communication similar to that in the first embodiment can be performed. At that time, heat generated in electronic components 50 and the transceiver IC 10 and then thermally conducted to the transceiver circuit board 20 is thermally conducted to the antenna circuit board 32 also from the inner peripheral surface of the recessed portion 20g and the board side surface 20i.

Therefore, a heat amount conducted from the transceiver circuit board 20 to the antenna circuit board 32 is more increased than that in the first embodiment. However, the transceiver circuit board 20 has a thermal conductivity much less than thermal conductivity of a metal. For example, copper has thermal conductivity of 400 W/(m·K), and therefore, an FR4 board has a thermal conductivity that is only 0.2% of that of the copper.

In a case where the board material of the antenna circuit board 32 is, for example, an LCP or a fluorine-based material, the antenna circuit board 32 has a thermal conductivity that is approximately 63% or 25% of the thermal conductivity of the FR4 board, respectively. Therefore, heat is more hardly thermally conducted compared with metals, by just forming the transceiver circuit board 20 of the FR4 board, but in the case of using, as the board material of the antenna circuit board 32, the material having the thermal conductivity smaller than that of the FR4 board, the heat conduction from the transceiver circuit board 20 is further reduced.

On the other hand, the thermal conductance of second connecting portions 40b and the thermal conductance of first connecting portions 40a in the transceiver IC 10 are the same as those of the first embodiment.

Therefore, a temperature increase amount in the antenna circuit board 32 is substantially the same as a temperature increase in the antenna circuit board 30 of the first embodiment.

Accordingly, the circuit board 102 of the present embodiment has operation substantially similar to that of the first embodiment.

In addition, according to the circuit board 102 of the present embodiment, when the antenna circuit board 32 is fixed to the transceiver circuit board 20, the protruding portion 32B can be aligned by being fitted into the recessed portion 20g. Therefore, assembly of the circuit board 102 is more simplified.

As described above, according to the circuit board 102 of the present embodiment and the electronic device such as a wireless communication device including the circuit board 102, deterioration of circuit characteristics and degradation of reliability can be suppressed even though a mounted electronic element generates the heat.

### Third Embodiment

A circuit board and an electronic device according to a third embodiment of the present invention will be described.

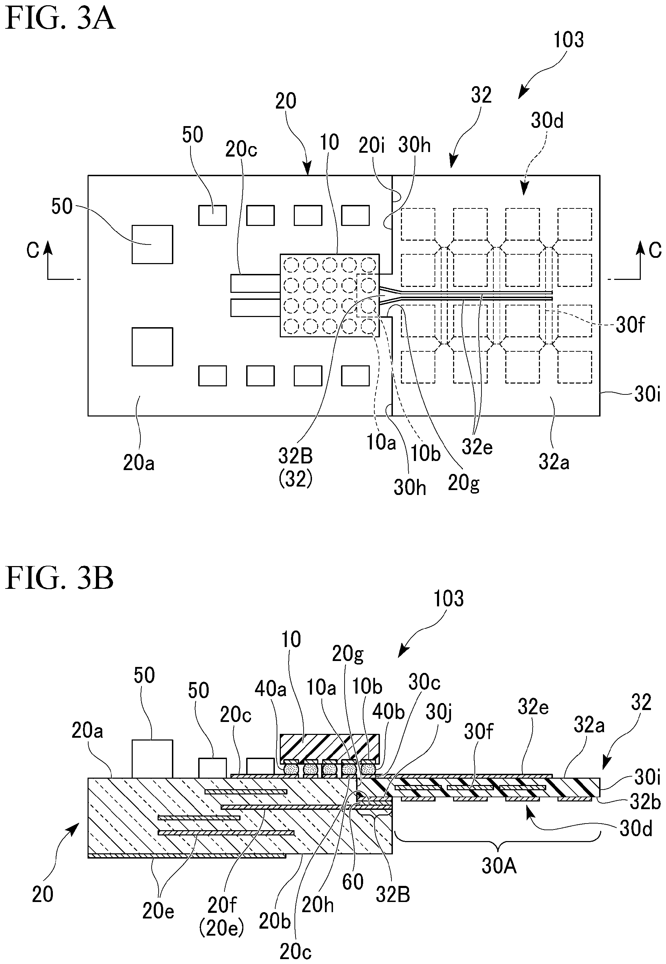

Fig. 3A is a schematic plan view showing an exemplary example of a circuit board according to the third embodiment. Fig. 3B is a cross-sectional view taken along a line C-C in Fig. 3A.

As shown in Figs. 3A and 3B, a circuit board 103 of the present embodiment is an exemplary case where an antenna circuit board 32 and a transceiver circuit board 20 are fixed by a bonding layer 60 (see Fig. 3B) in the circuit board 102 of the second embodiment described above.

In the following, different points from the second embodiment will be mainly described in connection with the bonding layer 60.

In the present embodiment, the bonding layer 60 is formed between a bottom surface 20h of a recessed portion 20g and a second surface 32b positioned at a protruding portion 32B of the antenna circuit board 32.

As the bonding layer 60, for example, cured products of a non-conductive resin adhesive, a conductive adhesive, and conductive paste, solder, or the like may be used.

In a case where the bonding layer 60 is formed of the cured product of the non-conductive resin adhesive, it is preferable that the cured product has a thermal conductivity lower than thermal conductivity of a board material of the transceiver circuit board 20. When the cured product of the resin adhesive has a thermal conductivity lower than the thermal conductivity of the board material of the transceiver circuit board 20, thermal conduction from the bottom surface 20h of the recessed portion 20g of the transceiver circuit board 20 to the protruding portion 32B is reduced.

However, in a case of using the resin adhesive, the bonding layer 60 is formed in a region where contact portions of GND patterns 20f and 30j are not non-conductive.

The circuit board 103 of the present embodiment is the exemplary case where a fixing method of the transceiver circuit board 20 and the antenna circuit board 32 is limited to adhering.

Therefore, according to the circuit board 103 of the present embodiment and the electronic device such as a wireless communication device including the circuit board 103, even though a mounted electronic element generates heat, deterioration of circuit characteristics and degradation of reliability can be suppressed in a manner similar to the second embodiment.

Particularly, according to the present embodiment, thermal conduction from the transceiver circuit board 20 to the antenna circuit board 32 can be further reduced by appropriately selecting the material of the bonding layer 60.

Furthermore, according to the present embodiment, it is possible to appropriately adjust a level difference between first surfaces 20a and 32a in the circuit board 103 by appropriately adjusting a thickness of the bonding layer.

### Fourth Embodiment

A circuit board and an electronic device according to a fourth embodiment of the present invention will be described.

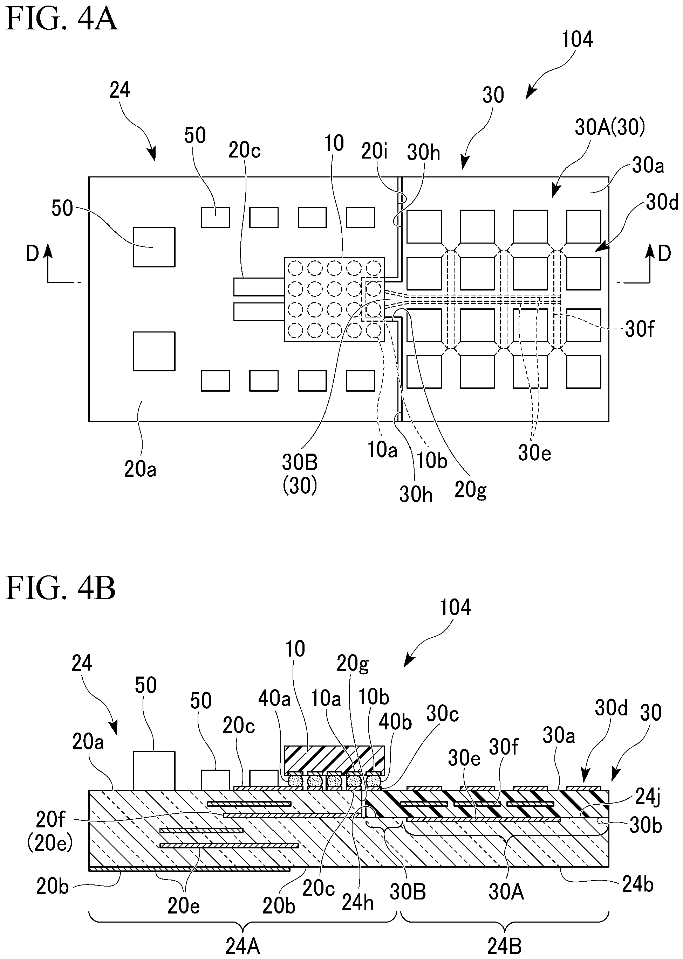

Fig. 4A is a schematic plan view showing an exemplary example of a circuit board according to the fourth embodiment. Fig. 4B is a cross-sectional view taken along a line D-D in Fig. 4A.

As shown in Figs. 4A and 4B, a circuit board 104 of the present embodiment includes a transceiver circuit board 24 (first board) instead of the transceiver circuit board 20 of a circuit board 101 of the first embodiment.

In the following, different points from the first embodiment will be mainly described.

As shown in Fig. 4B, the transceiver circuit board 24 is a plate-like member with steps, and includes a board body 24A and a flat plate portion 24B in a longitudinal direction thereof.

The transceiver circuit board 24 has an outer shape in which the flat plate portion 24B having a width same as a width in a short direction of the transceiver circuit board 20 extends from the board side surface 20i of the transceiver circuit board 20 of the first embodiment in a range between a bottom surface 24h of a recessed portion 20g and a second surface 20b.

The board body 24A of the transceiver circuit board 24 has a shape portion corresponding to the transceiver circuit board 20 of the first embodiment, and also is a plate member including a first surface 20a, the second surface 20b, and the recessed portion 20g which are similar to those of the transceiver circuit board 20. However, a board side surface 20i of the board body 24A is formed in a height range from the first surface 20a to the bottom surface 24h of the recessed portion 20g.

The bottom surface 24h is formed at a height similar to that of a bottom surface 20h of a recessed portion 20g of the first embodiment.

The flat plate portion 24B is formed in a manner such that the first surface 24j and the bottom surface 24h of the board body 24A are located on the same plane, and the second surface 24b and the second surface 20b of the board body 24A are located on the same plane, respectively.

Similar to the first embodiment, a protruding portion 30B of the antenna circuit board 30 is arranged on the bottom surface 24h of the recessed portion 20g of the transceiver circuit board 24.

A board body 30A of the antenna circuit board 30 is arranged on the first surface 24j of the flat plate portion 24B. The first surface 24j of the flat plate portion 24B may be larger or smaller than the board body 30A. In the example shown in Fig. 4A, the first surface 24j extends in a range exactly overlapping with a second surface 30b positioned at the board body 30A of the antenna circuit board 30.

The board body 24A may have a surface and an inner layer having constitutions similar to those of the transceiver circuit board 20 of the first embodiment. However, a GND pattern 20f can extend onto the first surface 24j of the flat plate portion 24B. In this case, the GND pattern 20f can be connected, on the first surface 24j of the flat plate portion 24B, to a GND pattern provided on the second surface 30b positioned at the board body 30A of the antenna circuit board 30. Therefore, the GND pattern 20f may be or may not be provided on the bottom surface 24h of the recessed portion 20g. Fig. 4B shows an exemplary case where the GND pattern 20f is not provided on the bottom surface 24h as an example.

With this constitution, the circuit board 104 includes gaps similar to those of the first embodiment, and the gaps are provided between an outer peripheral surface of the protruding portion 30B and an inner peripheral surface of the recessed portion 20g and between the board side surfaces 30h and 20i, respectively.

The antenna circuit board 30 of the present embodiment is fixed to at least one of the bottom surface 24h of the recessed portion 20g and the first surface 24j of the flat plate portion 24B by any one of fixing methods exemplified in the first embodiment.

Similar to the first embodiment, a GND connecting portion between the transceiver circuit board 24 and the antenna circuit board 30 may be formed between the bottom surface 24h and the second surface 30b positioned at the protruding portion 30B or between the first surface 24j of the flat plate portion 24B and the second surface 30b positioned at the board body 30A.

The circuit board 104 of the present embodiment has a constitution similar to that of the circuit board 101 of the first embodiment, except that the second surface 30b of the antenna circuit board 30 is supported by the flat plate portion 24B of the transceiver circuit board 24.

Therefore, the entire second surface 30b of the antenna circuit board 30 abuts on the bottom surface 24h of the recessed portion 20g of the transceiver circuit board 24 and the first surface 24j of the flat plate portion 24B of the transceiver circuit board 24. Consequently, the contact area between the antenna circuit board 30 and the transceiver circuit board 24 is larger than the contact area between an antenna circuit board 30 and the transceiver circuit board 20 of the first embodiment. Therefore, the thermal conductance between the antenna circuit board 30 and the transceiver circuit board 24 is larger than the thermal conductance between the antenna circuit board 30 and the transceiver circuit board 20 of the first embodiment.

However, since the thermal conductance by the contact between the boards is much smaller than the thermal conductance by contact between metal portions, a temperature increase in the antenna circuit board 30 can be kept within an allowable range.

Particularly, the flat plate portion 24B of the present embodiment extends from the board body 24A, and electronic components to be heat sources, such as electronic components 50 and a transceiver IC 10, are not mounted on the flat plate portion 24B.

Therefore, the flat plate portion 24B is a member that increases a heat capacity of the transceiver circuit board 24, and heat generated in the board body 24A is dispersed. Furthermore, the second surface 24b exposed to the air functions as a heat dissipation surface in the flat plate portion 24B.

As a result, the flat plate portion 24B also functions as a thermal buffer member against the board body 24A, and therefore, depending on a heat dissipation amount, a temperature increase may be more reduced than a temperature increase in the antenna circuit board 30 of the first embodiment. For example, when the flat plate portion 24B is made to abut on a member to be a heat sink, cooling of the antenna circuit board 30 can be facilitated.

Furthermore, according to the present embodiment, the antenna circuit board 30 can be fixed to the first surface 24j of the flat plate portion 24B that is larger than the bottom surface 24h. In this case, thermal deformation of the antenna circuit board 30 is suppressed.

As described above, according to the circuit board 104 of the present embodiment and the electronic device such as a wireless communication device including the circuit board 104, even though a mounted electronic element generates heat, deterioration of circuit characteristics and degradation of reliability can be suppressed in a manner similar to the first embodiment.

### Fifth Embodiment

A circuit board and an electronic device according to a fifth embodiment of the present invention will be described.

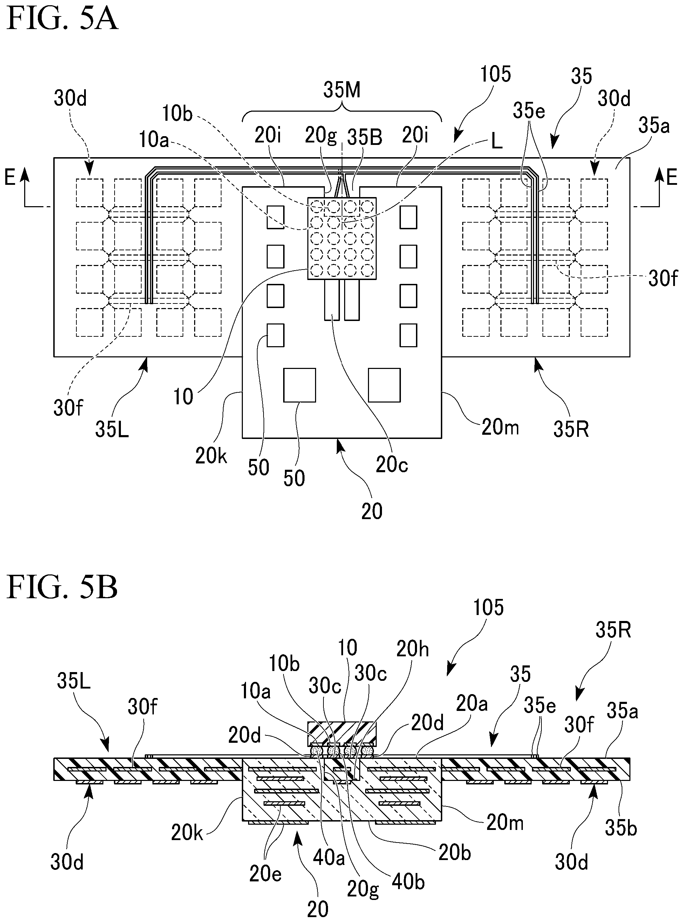

Fig. 5A is a schematic plan view showing an exemplary example of a circuit board according to the fifth embodiment. Fig. 5B is a cross-sectional view taken along a line E-E in Fig. 5A.

As shown in Figs. 5A and 5B, a circuit board 105 of the present embodiment includes an antenna circuit board 35 (second board) instead of the antenna circuit board 32 of the circuit board 102 of the second embodiment described above.

In the following, different points from the second embodiment will be mainly described.

The antenna circuit board 35 has a constitution similar to that of the antenna circuit board 32 of the second embodiment, except that an outer shape in the plan view and a wiring pattern are different.

As shown in Fig.5A, the antenna circuit board 35 includes a first flat plate portion 35L, a second flat plate portion 35R, a middle coupling portion 35M, and a protruding portion 35B, and as a whole, is formed in an E-shaped plate in the plan view. A material of the antenna circuit board 35 is similar to a material of the antenna circuit board 32 of the second embodiment.

A first surface 35a of the antenna circuit board 35 is arranged on a plane same as a first surface 20a of a transceiver circuit board 20. However, there may be a level difference between the first surfaces 35a and 20a as far as there is no problem in connection to the transceiver IC 10.

Each of the first flat plate portion 35L and the second flat plate portion 35R has a constitution of a rectangular plate similar to that of a board body 30A of the second embodiment.

The first flat plate portion 35L and the second flat plate portion 35R are connected by the middle coupling portion 35M with gaps capable of interposing board side surfaces 20k and 20m formed in a direction orthogonal to a board side surface 20i of the transceiver circuit board 20.

The middle coupling portion 35M is arranged in a manner facing the board side surface 20i of the transceiver circuit board 20. Similar to a protruding portion 32B of the second embodiment, an RF input/output terminal 30c is formed on the first surface 35a positioned at the protruding portion 35B.

Each of the first flat plate portion 35L and the second flat plate portion 35R have a planar antenna 30d formed on the second surface 35b on an opposite side of the first surface 35a, and the planar antenna is similar to that of the second embodiment. An antenna transmission line 30f similar to that of the second embodiment is provided in an inner layer of each of the first flat plate portion 35L and the second flat plate portion 35R. Each antenna transmission line 30f is electrically connected to the planar antenna 30d through a conductor such as a via (not shown).

An antenna transmission line 35e is formed on the first surface 35a in each of the first flat plate portion 35L and the second flat plate portion 35R, and the antenna transmission line 35e is electrically connected to the antenna transmission line 30f through a conductor such as a via (not shown). Each antenna transmission line 35e extends onto the first surface 35a positioned at the middle coupling portion 35M and the protruding portion 35B in order to provide connection to each RF input/output terminal 30c at the protruding portion 35B. Each antenna transmission line 35e is formed in an E-shaped pattern passing through a center in each width direction of the E-shaped antenna circuit board 35.

However, each antenna transmission line 35e branched toward the protruding portion 35B from the middle coupling portion 35M is connected to each antenna transmission line 30f through a conductor such as a via (not shown). Each antenna transmission line 30f is connected to each planar antenna 30d through a conductor such as a via (not shown).

In the circuit board 105, it is more preferable that a shape of the antenna circuit board 35 and pattern arrangement, wire lengths, and the like of the planar antennas 30d and the antenna transmission lines 35e and 35f on the antenna circuit board 35 be line-symmetrical with respect to an axial line L (see Fig. 5A). Here, the axial line L is an axial line passing between the respective RF input/output terminals 30c and extending in a protruding direction of the protruding portion 35B in the plan view.

The protruding portion 35B of the antenna circuit board 35 in the circuit board 105 of the present embodiment is fixed to the transceiver circuit board 20 by being fixed to a bottom surface 20h of a recessed portion 20g in a manner similar to the protruding portion 32B of the second embodiment.

Similar to the second embodiment, the transceiver IC 10 of the present embodiment is electrically connected to the antenna circuit board 35 and the transceiver circuit board 20 via second connecting portions 40b and first connecting portions 40a, respectively.

Therefore, the circuit board 105 of the present embodiment is the exemplary case where the first flat plate portion 35L and the second flat plate portion 35R each having the planar antenna 30d are arranged adjacent to the board side surfaces 20k and 20m of the transceiver circuit board 20 while interposing the transceiver circuit board 20 therebetween.

According to the circuit board 105, the antenna circuit board 35 has a shape different from that of the antenna circuit board 32 of the second embodiment, but the magnitude of the thermal conductance in the second connecting portions 40b and the magnitude of the thermal conductance in the first connecting portions 40a are similar to that of the second embodiment.

A contact state between the transceiver circuit board 20 and the antenna circuit board 35 is a state in which the board side surfaces 20i, 20k, and 20m contact the middle coupling portion 35M and board side surfaces of the first flat plate portion 35L and the second flat plate portion 35R in addition to the contact between the recessed portion 20g and the protruding portion 35B. Therefore, compared with the second embodiment, a thermal conduction amount between the boards is more increased in accordance with the amount of increase of the contact area between the boards.

However, in the case where the contact area between the board side surfaces is sufficiently reduced compared with the entire surface area of the transceiver circuit board 20 like the present embodiment, an increase amount in the thermal conduction caused by the increase in the contact area can also be decreased to an allowable value or less.

Thus, according to the circuit board 105 of the present embodiment and the electronic device such as a wireless communication device including the circuit board 105, even though a mounted electronic element generates heat, deterioration of circuit characteristics and degradation of reliability can be suppressed in a manner similar to the second embodiment, except for the increase amount in the thermal conduction caused by the increase in the contact area between the board side surfaces of the transceiver circuit board 20 and the antenna circuit board 35.

Particularly, in the present embodiment, the contact area between the board side surfaces may be made to zero by providing gaps between the board side surfaces of the transceiver circuit board 20 and the antenna circuit board 35 in a manner similar to the first embodiment. In this case, since thermal conduction through the board side surfaces of the transceiver circuit board 20 is eliminated, thermal conduction from the transceiver circuit board 20 can be reduced to the same extent as the first embodiment.

Note that, in the above description of the respective embodiments, the description has been provided by using the exemplary case where the transceiver IC 10 that is the electronic element is connected to the first board and the second board by the flip chip mounting method. However, as far as the electronic element can be electrically connected to the first board and the second board, the method of connecting the electronic element to the first board and the second board is not limited to bump connection like the flip chip mounting method. For example, the electronic element may be connected to the first board and the second board by wire bonding.

In the above description of the respective embodiments, the description has been mainly provided by using the exemplary case where the first connecting portion and the second connecting portion electrically connect the electronic element to the first board and the second board. However, the electronic element may be provided with a physical connecting portion in a space with at least one of the first board and the second board, and the physical connection is connected by the physical contact. In this case, the thermal conductance of the connecting portions is calculated by additionally considering a thermal conduction path through the physical connecting portion in addition to the electrical connecting portions.

For example, in the first embodiment, in a case where the transceiver IC 10 is fixed to the transceiver circuit board 20 and the antenna circuit board 30 by epoxy resin sealing, the magnitude of the thermal conductance is set by using not only the thermal conductance of the second connecting portions 40b and the thermal conductance of the first connecting portions 40a but also the thermal conductance of the epoxy resin considering the contact area of the epoxy resin.

In the above description of the respective embodiments, the description has been provided by using the exemplary case where heat generated by the electronic element is thermally conducted to the entire board material through the first connecting portion with the first board. However, a thermal conduction route may be formed inside the first board by combining materials having different levels of thermal conductivity in the first board, in addition to the wire portions. For example, a thermal via may be provided in the first board. In this case, a temperature increase as the entire first board can be suppressed by heat dissipation through the thermal via.

In the above description of the respective embodiments, the description has been provided by using the exemplary case where the material having the induced loss larger than zero and less than 0.02 is used as the board material of the second board because the wires and the circuit to transmit a high-frequency signal are formed on the second board. However, depending on a frequency of a signal transmitted to the second board, a material having an induced loss of 0.02 or more may also be used as the board material of the second board.

In the above description of the respective embodiments, the description has been provided by using the exemplary case where the antenna transmission line and the antenna are formed on the surfaces different from each other in the second board. However, the antenna transmission line and the antenna may be formed on the same plane.

In the above description of the respective embodiments, the description has been provided by using the exemplary case where the wires and the circuit through which a high-frequency signal is transmitted are the antenna transmission line and the antenna in the second board, for example. However, the wire and the circuit through which the high-frequency signal is transmitted are not limited to the antenna transmission line and the antenna.

In the description of the fourth embodiment, the description has been provided by using the exemplary case where the antenna circuit board 30 is fixed to the flat plate portion 24B of the transceiver circuit board 24, but in the circuit board 104, the constitution of the antenna circuit board 30 may be integrally formed by appropriately depositing a board material and a conductive body material on the flat plate portion 24B, for example.

As described above, the preferable embodiments of the present invention have been described, but the present invention is not limited to the present embodiment. Additions, omissions, substitutions, and other modifications can be made in the scope without departing from the spirit of the present invention.

Furthermore, the present invention is not limited by the above description, and is limited only by the scope of the appended claims.

For example, in the respective embodiments excluding the fourth embodiment, the positional relation between the planar antenna 30d and the antenna transmission line 30e may be inverted in the thickness direction. For example, in the respective embodiments, in a case where there is no gap between any side surface of the first board and any side surface of the second board, the respective embodiments may be implemented by making a modification so as to form a gap.

### DESCRIPTION OF THE REFERENCE SYMBOLS

- 10:: Transceiver IC (electronic element)
- 10b:: First terminal
- 10a:: Second terminal
- 20, 24:: Transceiver circuit board (first board)
- 30, 32, 35:: Antenna circuit board (second board)
- 20a, 24j, 30a, 32a, 35a:: First surface
- 20b, 24b, 30b, 32b, 35b:: Second surface
- 20i, 20k, 20m, 30h, 30i:: Board side surface
- 20f, 30j:: GND pattern
- 20c:: Connection terminal
- 20g:: Recessed portion
- 24A,: 30A: Board body
- 24B:: Flat plate portion
- 30B, 32B, 35B:: Protruding portion
- 30c:: RF input/output terminal
- 30d:: Planar antenna
- 30e, 30f, 32e, 35e:: Antenna transmission line
- 35L:: First flat plate portion
- 35M:: Middle coupling portion
- 35R:: Second flat plate portion
- 40a:: First connecting portion (first connecting portion)
- 40b:: Second connecting portion (second connecting portion)
- 50:: Electronic component
- 60:: Bonding layer
- 101, 102, 103, 104, 105:: Circuit board

## Claims

1. A circuit board comprising:
a first board;
a second board;
an electronic element connected to the first board via a first connecting portion, and connected to the second board via a second connecting portion,
wherein a thermal conductance of the second connecting portion is smaller than a thermal conductance of the first connecting portion.

2. The circuit board according to claim 1, wherein the first board and the second board are arranged with a gap between each other.

3. The circuit board according to claim 1 or 2, wherein the first board and the second board are formed of materials different from each other.

4. The circuit board according to any one of claims 1 to 3, wherein the second board has a dielectric loss smaller than a dielectric loss of the first board.

5. The circuit board according to claim 4, wherein the second board has the dielectric loss larger than zero and smaller than 0.02.

6. The circuit board according to any one of claims 1 to 5, wherein the second board includes an antenna transmission line.

7. The circuit board according to any one of claims 1 to 6, wherein only the electronic element among electronic components is mounted on the second board.

8. An electronic device comprising the circuit board according to any one of claims 1 to 7.
